(19) Europäisches Patentamt

European Patent Office

Office européen des brevets

(11) Veröffentlichungsnummer: **0 082 167
B1**

(12) **EUROPÄISCHE PATENTSCHRIFT**

(45) Veröffentlichungstag der Patentschrift:
**16.10.85**

(21) Anmeldenummer: **82901960.3**

(22) Anmeldetag: **16.06.82**

(86) Internationale Anmeldenummer:
**PCT/DE 82/00128**

(87) Internationale Veröffentlichungsnummer:
**WO 83/00074 (06.01.83** Gazette 83/1)

(51) Int. Cl.⁴: **H 01 L 23/04,** H 01 L 23/36,
**H 01 L 23/30**

(54) **HALBLEITERGLEICHRICHTER.**

(30) Priorität: **24.06.81 DE 3124692**

(43) Veröffentlichungstag der Anmeldung:
**29.06.83 Patentblatt 83/26**

(45) Bekanntmachung des Hinweises auf die Patenterteilung:
**16.10.85 Patentblatt 85/42**

(84) Benannte Vertragsstaaten:
**DE FR GB**

(56) Entgegenhaltungen:
**FR - A - 2 258 709
FR - A - 2 421 465**

(73) Patentinhaber: **ROBERT BOSCH GMBH, Postfach 50,
D-7000 Stuttgart 1 (DE)**

(72) Erfinder: **SCHWENK, Siegfried, Hegelstrasse 8,
D-7410 Reutlingen (DE)**
Erfinder: **HÖSSLER, Andreas, H.-Ehlersstrasse 40,
D-7410 Reutlingen (DE)**
Erfinder: **HEYKE, Klaus, Bodäckerstrasse 23,
D-7410 Reutlingen (DE)**
Erfinder: **WALLRAUCH, Alexander, Keplerstrasse 18,
D-7413 Gomaringen (DE)**

# Beschreibung

## Stand der Technik

Die Erfindung geht aus von einem Halbleitergleichrichter nach dem ersten Teil eines der Ansprüche 1, 2 oder 3. Aus der DE-C-15 89 555 ist bereits ein Halbleitergleichrichter dieser Art bekannt, bei dem das zweite Teilstück des ersten Anschlussleiters einen wesentlich grösseren Durchmasser als das erste Teilstück hat und bei dem die Kunstharzmasse den äussersten Mantel bildet und die Form eines Kegelstumpfes hat. Dieser Halbleitergleichrichter hat den Nachteil, dass der Kunstharzmantel durch Spritzpressen hergestellt werden muss.

Ferner sind Halbleitergleichrichter gemäss den ersten Teilen der Ansprüche 1 bis 3 aus der FR-A-2 421 465 bekannt.

## Vorteile der Erfindung

Die erfindungsgemässen Halbleitergleichrichter mit den kennzeichnenden Merkmalen des Anspruchs 1 bzw. des Anspruchs 2 bzw. des Anspruchs 3 haben demgegenüber den Vorteil, dass die Kunstharzmasse durch Ausgiessen der zylindermantelförmig ausgebildeten Hülse bzw. des über das zweite Teilstück des ersten Anschlussleiters hinausragenden Teils des Durchzuges bzw. durch Ausgiessen des konisch geöffneten Teilbereichs des Kühlblechs hergestellt werden kann, nachdem des aus dem Halbleiterplättchen und seinen beiden Anschlussleitern bestehende zusammengelötete System mittels des zweiten Teilstücks des ersten Anschlussleiters bereits in das Kühlblech eingepresst worden ist. Eine Weiterbildung des Gegenstandes nach einem der Ansprüche 1 bis 3 bringt Anspruch 4 und Anspruch 5.

## Zeichnung

Drei Ausführungsbeispiele des erfindungsgemässen Halbleitergleichrichters sind in der Zeichnung dargestellt und in der nachfolgenden Beschreibung näher erläutert. Es zeigen:

Fig. 1 einen Axialschnitt durch das erste Ausführungsbeispiel,

Fig. 2 einen Axialschnitt durch das zweite Ausführungsbeispiel,

Fig. 3 einen Axialschnitt durch das dritte Ausführungsbeispiel.

## Beschreibung der Ausführungsbeispiele

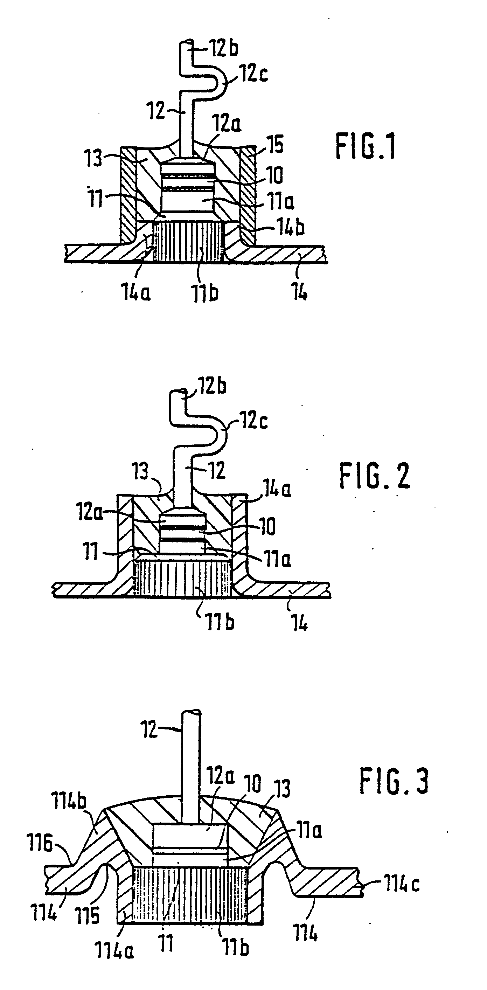

Fig. 1 zeigt einen im wesentlichen rotationssymmetrisch ausgebildeten Halbleitergleichrichter mit einem Halbleiterplättchen 10 und zwei Anschlussleitern 11 und 12, die an je eine der beiden Hauptoberflächen des Halbleiterplättchens 10 angelötet sind. Der erste Anschlussleiter 11 bildet dabei einen bolzenförmigen massiven Metallsockel, der aus einem ersten, mit dem Halbleiterplättchen 10 verlöteten Teilstück 11a und einem zweiten, mit einer Rändelung versehenen Teilstück 11b besteht. Der zweite Anschlussleiter 12 ist als Kopfdraht ausgebildet. Der Kopfteil 12a dieses Kopfdrahtes ist dabei mit dem Halbleiterplättchen 10 verlötet. Ferner ist eine Kunstharzmasse 13 vorgesehen, die den Rand des Halbleiterplättchens 10, das erste Teilstück 11a

des ersten Anschlussleiters 11 und Teile des zweiten Anschlussleiters 12 abdeckt. Das mit der Rändelung versehene zweite Teilstück 11b des ersten Anschlussleiters 11 ist in ein zur Kühlung des Gleichrichters dienendes Kühlblech 14 eingepresst, das im Bereich dieses zweiten Teilstücks 11b einen Durchzug 14a bildet, der sich über das ganze zweite Teilstück 11b erstreckt. Das freie Ende 14b des Durchzuges 14a bedeckt dabei denjenigen Teil des zweiten Teilstücks 11b, der sich an das erste Teilstück 11a anschliesst. Zur Begrenzung der Kunstharzmasse 13 in radialer Richtung ist eine zylindermantelförmig ausgebildete Hülse 15 vorgesehen, die durch Fügen über den Durchzug 14a gestülpt ist. Die Kunstharzmasse 13 erstreckt sich dabei in axialer Richtung über den Kopfteil 12a des zweiten Anschlussleiters 12 hinaus. Der drahtförmige Teil 12b des zweiten Anschlussleiters 12 ist mit einer Zugentlastung 12c versehen.

In Fig. 2 ist ein zweites Ausführungsbeispiel dargestellt. Es handelt sich dabei hier wieder um einen im wesentlichen rotationssymmetrisch ausgebildeten Halbleitergleichrichter mit einem Halbleiterplättchen 10 und zwei Anschlussleitern 11 und 12, die an je einer der beiden Hauptoberflächen des Halbleiterplättchens 10 angelötet sind und von denen der erste einen bolzenförmigen massiven Metallsockel 11 bildet. Der erste Anschlussleiter 11 besteht auch hier wieder aus einem ersten, mit dem Halbleiterplättchen 10 verlöteten Teilstück 11a und einem zweiten, mit einer Rändelung versehenen Teilstück 11b. Das zweite Teilstück 11b hat jedoch im Vergleich zum Ausführungsbeispiel nach Fig. 1 einen wesentlich grösseren Durchmesser als das erste Teilstück 11a. Der zweite Anschlussleiter 12 ist auch hier wieder als Kopfdraht ausgebildet. Der Kopfteil 12a dieses Kopfdrahtes ist dabei mit dem Halbleiterplättchen 10 verlötet. Ferner ist wieder eine Kunstharzmasse 13 vorgesehen, die den Rand des Halbleiterplättchens 10, das erste Teilstück 11a des ersten Anschlussleiters 11 und Teile des zweiten Anschlussleiters 12 abdeckt. Das mit der Rändelung versehene zweite Teilstück 11b ist auch hier wieder in einen Durchzug 14a eingepresst, der Bestandteil eines zur Kühlung des Gleichrichters dienenden Kühlblechs 14 ist. Der Durchzug 14a überragt jedoch das zweite Teilstück 11b in Richtung zum ersten Teilstück 11a hin und dient gleichzeitig zur Begrenzung der Kunstharzmasse 13 in radialer Richtung. Die Kunstharzmasse 13 und der Durchzug 14a erstrecken sich hierbei in axialer Richtung über den Kopfteil 12a des zweiten Anschlussleiters 12 hinaus. Der drahtförmige Teil 12b des zweiten Anschlussleiters 12 ist mit einer Zugentlastung 12c versehen.

Der in Fig. 3 dargestellte rotationssymmetrisch ausgebildete Halbleitergleichrichter enthält ein Halbleiterplättchen 10 und zwei Anschlussleiter 11 und 12, die an je eine der beiden Hauptoberflächen des Halbleiterplättchens 10 angelötet sind. Der erste Anschlussleiter 11 bildet dabei einen bolzenförmigen massiven Metallsockel, der aus einem ersten, mit dem Halbleiterplättchen 10 verlöteten Teilstück 11a und einem zweiter, mit einer Rändelung versehenen Teilstück 11b besteht. Das zweite Teilstück 11b

hat dabei einen grösseren Durchmesser als das erste Teilstück 11a. Ferner ist eine Kunstharzmasse 13 vorgesehen, die den Rand des Halbleiterplättchens 10, das erste Teilstück 11a des ersten Anschlussleiters 11 und Teile des zweiten Anschlussleiter 12 abdeckt. Das zweite Teilstück 11b ist in ein zur Kühlung des Gleichrichters dienendes Kühlblech 114 eingepresst, das im Bereich des zweiten Teilstücks 11b einen Zylindermantel 114a bildet, dann in einen konisch geöffneten Teilbereich 114b übergeht, der als Berandung für die Kunstharzmasse 13 dient, und nach einer ersten Abknickung 115 und einer zweiten Abknickung 116 in einen ebenen Bereich 114c übergeht. Der zweite Anschlussleiter 12 ist als Kopfdraht ausgebildet, wobei der Kopfteil 12a dieses Kopfdrahtes mit dem Halbleiterplättchen 10 verlötet ist. Die Kunstharzmasse 13 erstreckt sich in axialer Richtung über den Kopfteil 12a des Anschlussleiters 12 hinaus.

Bei allen drei Ausführungsbeispielen kann auf den Rand des Halbleiterplättchens 10 und auf die an das Halbleiterplättchen 10 angrenzenden Oberflächenbereiche der beiden Anschlussleiter 11, 12 eine aus einem Abdecklack bestehende Oberflächenschutzschicht aufgebracht sein, die von der Kunstharzmasse 13 bedeckt wird.

## Patentansprüche

1. Im wesentlichen rotationssymmetrisch ausgebildeter Halbleitergleichrichter mit einem Halbleiterplättchen (10) und zwei Anschlussleitern (11, 12), die an je eine der beiden Hauptoberflächen des Halbleiterplättchens (10) angelötet sind und von denen der erste (11) einen bolzenförmigen massiven Metallsockel bildet, der aus einem ersten, mit dem Halbleiterplättchen (10) verlöteten Teilstück (11a) und einem zweiten, mit einer Rändelung versehenen Teilstück (11b) besteht, mit einer Kunstharzmasse (13), die den Rand des Halbleiterplättchens (10), das erste Teilstück (11a) des ersten Anschlussleiters (11) und Teile des zweiten Anschlussleiters (12) abdeckt, und mit einer zur Begrenzung der Kunstharzmasse (13) in radialer Richtung dienenden zylindermantelförmig ausgebildeten Hülse (15) bei dem das zweite Teilstück (11b) des ersten Anschlussleiters (11) in ein zur Kühlung des Gleichrichters dienendes Kühlblech (14) eingepresst ist, das im Bereich dieses zweiten Teilstücks (11b) einen Durchzug (14a) bildet, dadurch gekennzeichnet, dass der Durchzug sich über das ganze zweite Teilstück (11b) erstreckt, wobei das freie Ende (14b) des Durchzuges (14a) denjenigen Teil des zweiten Teilstücks (11b) bedeckt, der sich an das erste Teilstück (11a) anschliesst, und dass die Hülse (15) durch Fügen über Durchzug (14a) gestülpt ist.

2. Im wesentlichen rotationssymmetrisch ausgebildeter Halbleitergleichrichter mit einem Halbleiterplättchen (10) und zwei Anschlussleitern (11, 12), die an je eine der beiden Hauptoberflächen des Halbleiterplättchens (10) angelötet sind und von denen der erste (11) einen bolzenförmigen massiven Metallsockel bildet, der aus einem ersten, mit dem Halbleiterplättchen (10) verlöteten Teilstück (11a) und einem zweiten, mit einer Rändelung versehenen Teilstück (11b) besteht, und mit einer Kunstharzmasse (13), die den Rand des Halbleiterplättchens (10), das erste Teilstück (11a) des ersten Anschlussleiters (11) und Teile des zweiten Anschlussleiters (12) abdeckt, bei dem das zweite Teilstück (11b) des ersten Anschlussleiters (11) einen grösseren Durchmesser als das erste Teilstück (11a) hat, und das zweite Teilstück (11b) in einen Durchzug (14a) eingepresst ist, der Bestandteil eines zur Kühlung des Gleichrichters dienenden Kühlblechs (14) ist, dadurch gekennzeichnet, dass der Durchzug (14a) das zweite Teilstück (11b) in Richtung zum ersten Teilstück (11a) hin und darüber hinaus überragt und zur Begrenzung der Kunstharzmasse (13) in radialer Richtung dient.

3. Im wesentlichen rotationssymmetrisch ausgebildeter Halbleitergleichrichter mit einem Halbleiterplättchen (10) und zwei Anschlussleitern (11, 12), die an je eine der beiden Hauptoberflächen des Halbleiterplättchens (10) angelötet sind und von denen der erste (11) einen bolzenförmigen massiven Metallsockel bildet, der aus einem ersten, mit dem Halbleiterplättchen (10) verlöteten Teilstück (11a) und einem zweiten, mit einer Rändelung versehenen Teilstück (11b) besteht, und mit einer Kunstharzmasse (13), die den Rand des Halbleiterplättchens (10), das erste Teilstück (11a) des ersten Anschlussleiters (11) und Teile des zweiten Anschlussleiters (12) abdeckt, bei dem das zweite Teilstück (11b) einen grösserem Durchmesser als das erste Teilstück (11a) hat und in ein zur Kühlung des Gleichrichters dienendes Kühlblech (114) eingepresst ist, das im Bereich des zweiten Teilstücks (11b) einen Zylindermantel (114a) bildet, dadurch gekennzeichnet, dass das Kühlblech im Bereich des ersten Teilstücks in einen konisch geöffneten Teilbereich (114b) übergeht, der als Berandung für die Kunstharzmasse (13) dient, und nach einer ersten Abknickung (115) und einer zweite Abknickung (116) in einen ebenen Bereich (114c) übergeht.

4. Halbleitergleichrichter nach einem der Ansprüche 1 bis 3, dadurch gekennzeichnet, dass der zweite Anschlussleiter (12) als Kopfdraht ausgebildet ist, dass der Kopfteil (12a) dieses Kopfdrahtes mit dem Halbleiterplättchen (10) verlötet ist und dass die Kunstharzmasse (13) sich in axialer Richtung über den Kopfteil (12a) hinaus erstreckt.

5. Halbleitergleichrichter nach einem der Ansprüche 1 bis 4, dadurch gekennzeichnet, dass auf den Rand des Halbleiterplättchens (10) angrenzenden Oberflächenbereiche der beiden Anschlussleiter (11, 12) eine aus einem Abdecklack bestehende Oberflächenschutzschicht aufgebracht ist, die von der Kunstharzmasse (13) bedeckt wird.

## Claims

1. Essentially rotationally symmetrically constructed semi-conductor rectifier comprising a semi-conductor wafer (10) and two connecting conductors (11, 12) which are soldered onto one each of the two main surfaces of the semi-conductor wafer (10) and the first (11) of which forms a bolt-shaped solid metal plinth consisting of a first part piece (11) which is soldered to the semi-conductor wafer (10) and a second part piece (11b) which is provided with knurling, a synthetic resin compound (13) which covers the edge of the semi-conductor wafer (10), the first part piece (11a) of the first connecting conductor (11) and parts of the second connecting conductor (12), and comprising a sleeve (15) which is constructed in the form of a cylindrical jacket and serves to limit the synthetic resin compound (13) in the radial direction, in which rectifier the second part piece (11b) of the first connecting conductor (11) is pressed into a heat-sink plate (14) which is used for cooling the rectifier and which forms a rim hole (14a) in the area of this second part piece (11b), characterized in that the rim hole extends over the entire second part piece (11b), the free end (14b) of the rim hole (14a) covering the section of the second part piece (11b) adjoining the first part piece (11a), and that the sleeve (15) is drawn over the rim hole (14a).

2. Essentially rotationally symmetrically constructed semi-conductor rectifier comprising a semi-conductor wafer (10) and two connecting conductors (11, 12) which are soldered onto one each of the two main surfaces of the semi-conductor wafer (10) and the first (11) of which forms a bolt-shaped solid metal plinth consisting of a first part piece (11) which is soldered to the semi-conductor wafer (10) and a second part piece (11b) which is provided with knurling, and a synthetic resin compound (13) which covers the edge of the semi-conductor (10), the first part piece (11a) of the first connecting conductor (11) and part of the second connecting conductor (12), in which rectifier the second part piece (11b) of the first connecting conductor (11) has a larger diameter than the first part piece (11a) and the second part piece (11b) is pressed into a rim hole (14a) which is a component of a heat-sink plate (14) used for cooling the rectifier, characterized in that the rim hole (14a) projects past the second part piece (11b) in the direction of the first part piece (11a) and beyond and is used for limiting the synthetic resin compounds (13) in the radial direction.

3. Essentially rotationally symmetrically constructed semi-conductor rectifier comprising a semi-conductor wafer (10) and two connecting conductors (11, 12) which are soldered onto one each of the two main surfaces of the semi-conductor wafer (10) and the first (11) of which forms a bolt-shaped solid metal plinth consisting of a first part piece (11) which is soldered to the semi-conductor wafer (10) and a second part piece (11b) which is provided with knurling, and a synthetic resin compound (13) which covers the edge of the semi-conductor (10), the first part piece (11a) of the first connecting conductor (11) and part of the second connecting conductor (12), in which rectifier the second part piece (11b) of the first connecting conductor (11) has a larger diameter than the first part piece (11a) and is pressed into a heat-sink plate (114) which is used for cooling the rectifier and which forms a cylindrical jacket (114a) in the area of the second part piece (11b), characterized in that in the area of the first part piece, the heat-sink plate changes into a conically opened part area (114b) which is used as an edge for the synthetic resin compound (13) and, after a first bend (115) and a second bend (116), changes into a level area (114c).

4. Semi-conductor rectifier according to one of Claims 1 to 3, characterized in that the second connecting conductor (12) is constructed as top wire, that the top section (12a) of this top wire is soldered to the semi-conductor wafer (10) and that the synthetic resin compound (13) extends in the axial direction past the top section (12a).

5. Semi-conductor rectifier according to one of Claims 1 to 4, characterized in that a surface protection layer consisting of a covering varnish is applied to surface areas adjoining the edge of the semi-conductor wafer (10), of the two connecting conductors (11, 12), which layer is covered by the synthetic resin compound (13).

**Revendications**

1. Redresseur à semi-conducteur réalisé essentiellement avec une symétrie de rotation, comportant une plaquette semi-conductrice (10) et deux conducteurs de raccordement (11, 12) qui sont soudés respectivement à chacune des deux surfaces supérieures de la plaquette semi-conductrice (10) et le premier (11) forme un socle métallique massif en forme de goujon qui se compose d'une première pièce (11a) soudée à la plaquette semi-conductrice (10) et d'une seconde pièce (11b) munie d'un moletage, et d'une masse de résine synthétique (13) qui recouvre le bord de la plaquette semi-conductrice (10), la première pièce (11a) du premier conducteur de raccordement (11) et les parties du second conducteur de raccordement (12), et une douille (15) en forme d'enveloppe cylindrique servant à limiter la masse de résine synthétique (13) dans la direction radiale, la seconde pièce (11b) du premier conducteur de raccordement (11) étant pressée dans une tôle de refroidissement (14) servant à refroidir le redresseur et qui forme un passage (14a) au niveau de cette seconde pièce (11b), caractérisé en ce que le passage s'étend sur toute la seconde pièce (11b) et l'extrémité libre (14b) du passage (14a) recouvre la partie de la seconde pièce (11b) qui se rattache à la première pièce (11a) et en ce que la douille (15) est emmanchée de force pardessus le passage (14a).

2. Redresseur à semi-conducteur ayant essentiellement une symétrie de rotation comportant une plaquette semi-conductrice (10) et deux conducteurs de raccordement (11, 12) qui sont soudés respectivement à chacune des surfaces supérieures de la plaquette semi-conductrice (10) et parmi lesquels le premier (11) forme un socle métallique massif en forme de goujon qui se compose d'une première pièce (11a) soudée à la plaquette semi-conductrice (10) et une seconde pièce (11b) munie d'un moletage, ainsi que d'une masse de résine synthétique (13) qui recouvre le bord de la plaquette semi-conductrice (10), la première pièce (11a) du premier conducteur de raccordement (11) et les parties du second conducteur de raccordement (12), la seconde pièce (11b) du premier conducteur de raccordement (11) ayant un plus grand diamètre que la première pièce (11a) et la se-

conde pièce (11b) étant pressée dans un passage (14a) qui fait partie d'une tôle de refroidissement (14) servant à refroidir le redresseur, caractérisé en ce que la passage (14a) de la seconde pièce (11b) va en direction de la première pièce (11a) et est en saillie par rapport à celle-ci et sert à limiter dans la direction radiale la masse de résine synthetique (13).

3. Redresseur à semi-conducteur essentiellement réalisé avec une symétrie de rotation, comprenant une plaquette semi-conductrice (10) et deux conducteurs de raccordement (11, 12) qui sont soudés respectivement sur chacune des deux faces supérieures de la plaquette semi-conductrice (10) et parmi lesquels le premier (11) forme un socle métallique massif en forme de goujon qui se compose d'une première pièce (11a) soudée à la plaquette semi-conductrice (10) et d'une seconde pièce (11b) munie d'un moletage, et d'une masse de résine synthétique (13) qui recouvre le bord de la plaquette semi-conductrice (10), la première pièce (11a) du premier conducteur de raccordement (11) et les parties du second conducteur de raccordement (12) la seconde pièce (11b) ayant un plus grand diamètre que la première pièce (11a) et étant pressée dans une tôle de refroidissement (114) servant au refroidissement du redresseur, et qui forme une enveloppe cylindrique (114) au niveau de la seconde pièce (11b), caractérisé en ce que la tôle de refroidissement devient au niveau de la première pièce une zone de pièce 114b ouverte de façon conique qui sert à border la masse de résine synthétique (13) et après un premier recourbement (115) et un second recourbement (116) devient une zone plane (114c).

4. Redresseur à semi-conducteur selon l'une des revendications 1 à 3, caractérisé en ce que le second conducteur de raccordement (12) est réalisé en forme de fli de tête, en ce que la partie de tête (12a) de ce fil de tête est soudée à la plaquette semi-conductrice (10) et en ce que la masse de résine synthétique (13) s'étend dans la direction radiale pardessus la partie de tête (12a).

5. Redresseur à semi-conducteur selon l'une des revendications 1 à 4, caractérisé en ce que sur le bord de la zone de surface supérieure adjacente à la plaquette semi-conductrice (10) des deux conducteurs de raccordement (11, 12) est appliquée une couche de protection de surface constituée par un vernis de recouvrement et qui est recouverte par la masse de résine synthétique (13).

FIG.1

FIG.2

FIG.3